(19) Europäisches Patentamt
European Patent Office
Office européen des brevets

(11) EP 0 553 469 B1

# (12) EUROPÄISCHE PATENTSCHRIFT

(45) Veröffentlichungstag und Bekanntmachung des Hinweises auf die Patenterteilung:
**19.03.1997 Patentblatt 1997/12**

(51) Int Cl.[6]: **C23C 16/44**, H01J 37/32

(21) Anmeldenummer: **92121509.1**

(22) Anmeldetag: **17.12.1992**

(54) **Verfahren zur schnellen und schonenden Reinigung von insbesondere beim Abscheiden und Ätzen von Schichten auf Siliziumsubstraten verwendeten Reaktionskammern durch Plasmaätzen**

Plasma-etching process for the rapid and damage-free cleaning of reaction chambers used principally in the deposition or etching of layers on silicon substrats

Procédé de nettoyage rapide et sans dommages par attaque plasma de chambres de réaction utilisées principalement pour le dépôt ou la gravure de couches sur des substrats de silicium

(84) Benannte Vertragsstaaten:
**AT DE FR GB IE NL**

(30) Priorität: **27.01.1992 DE 4202158**

(43) Veröffentlichungstag der Anmeldung:
**04.08.1993 Patentblatt 1993/31**

(73) Patentinhaber: **SIEMENS AKTIENGESELLSCHAFT**
**80333 München (DE)**

(72) Erfinder:
- **Gabric, Zvonimir**
  **W-8011 Zorneding (DE)**
- **Gschwandtner, Alexander, Dr. Dipl.-Physiker**
  **W-8000 München (DE)**
- **Spindler, Oswald, Dr. Dipl.-Chemiker**
  **W-8011 Vaterstetten (DE)**

(56) Entgegenhaltungen:
**EP-A- 0 354 853** **EP-A- 0 464 696**

- **PATENT ABSTRACTS OF JAPAN vol. 14, no. 312 (E-0948) 5. Juli 1990 & JP-A-02 102 528 (CHLORINE ENG) 16. April 1990**
- **PATENT ABSTRACTS OF JAPAN vol. 15, no. 291 (E-1093) 24. Juli 1991 & JP-A-03 102 824 (FUJITSU) 30. April 1991**
- **PATENT ABSTRACTS OF JAPAN vol. 11, no. 390 (E-567) 19. Dezember 1987 & JP-A-62 154 736 (HITACHI) 9. Juli 1987**
- **PATENT ABSTRACTS OF JAPAN vol. 12, no. 412 (E-676) 31. Oktober 1988 & JP-A-63 150 921 (FUJITSU) 23. Juni 1988**

EP 0 553 469 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

Printed by Jouve, 75001 PARIS (FR)

## Beschreibung

Die Erfindung betrifft ein Verfahren zur schnellen und schonenden Reinigung von beim Abscheiden und Ätzen von Schichten auf Siliziumsubstraten verwendeten Reaktionskammern durch Plasmaätzen, bei dem zur Reinigung der Reaktionskammer von an ihren inneren Oberflächen parasitär abgeschiedenen Schichten aus Siliziumoxiden oder -nitriden eine Ätzgasmischung verwendet wird, als deren Hauptbestandteil mindestens ein fluorierter Kohlenstoff, insbesondere $CF_4$ und/oder $C_2F_6$ vorgesehen wird.

Ein derartiges Verfahren ist aus der europäischen Patentanmeldung EP-A-354 853 bekannt.

Die Reinigung von Reaktionskammern, wie sie beispielsweise beim Abscheiden und Ätzen im Bereich der Werkstoffvergütung notwendig wird, gewinnt vor allem innerhalb der Prozeßfolge zur Herstellung von integrierten Schaltungen aus Siliziumsubstraten zunehmend an Bedeutung. Im Zusammenhang mit der Erhöhung der Chipintegrationsdichte macht sich auch eine verstärkte Notwendigkeit von hocheffektiven und fertigungstauglichen Reinigungsschritten bemerkbar. Als besonders kritisch hat sich dabei, neben der Scheibenreinigung, die spätestens nach einem bestimmten Durchsatz an Siliziumscheiben erforderliche Reinigung der in jedem Herstellungszyklus wiederholt zur Schichterzeugung bzw. zum Ätzen von Schichten verwendeten Reaktionskammern erwiesen. Deren innere Oberflächen werden während der Prozesse auch an ungünstigsten Stellen beschichtet bzw. verunreinigt. Diese parasitären Schichten führen mit der Zeit zu Störungen der Prozeßführung oder zu Verunreinigungen des zu beschichtenden bzw. zu ätzenden Werkstücks. Im vorliegenden Fall bestehen diese Schichten aus organischen Polymeren und/oder Oxiden und Nitriden von Silizium. Zum Stand der Abscheide- bzw. Ätztechnik wird auf D. Widmann et al, "Technologie hochintegrierter Schaltungen", Springer-Verlag 1988, insbesondere Abschnitte 3.1.1 und 5.2.3 sowie 5.3.5, hingewiesen.

Die genannte Störung der Prozesse bzw. die Kontamination zwingt zu häufigen Kammerreinigungen. Diese wiederum führen zu erhöhtem Teileverschleiß mit den anschließenden Ersatzteil und reitstellungskosten, zu hohem Wartungsaufwand hinsichtlich Personal und Arbeitszeit und nicht zuletzt zu Fertigungsausfällen aufgrund des geringen Durchsatzes und hoher Ausfallzeit. Diese Nachteile treten in besonders hohem Maße in Erscheinung, wenn die Reaktionskammern geöffnet und durch mechanisches Entfernen der Schichten und Beläge konventionell gereinigt wird. Als ähnlich nachteilig im Hinblick auf einen großen Aufwand bei der Arbeits-, Betriebs- und Entsorgungssicherheit erweist sich das bekannte Einleiten von Fluorwasserstoff-Dampf in die Reaktionskammer; dabei werden zwar oxidische und nitridische Schichten in die Gasphase überführt, jedoch ist die Langzeitstabilität der teilweise oberflächenveredelten Anlagenteile wegen der Aggressivität von HF gefährdet.

Da die Reaktionskammern heute meistens ohnehin für plasmaunterstütztes Abscheiden bzw. Ätzen ausgelegt sind, erfolgt die Kammerreinigung gegenwärtig üblicherweise durch In-Situ-Trockenätzen mittels im Plasma aktivierter Ätzgase. Dabei werden schichtauflösende Gase in die Reaktionskammer eingeleitet, die meist dort in einem mittels der vorhandenen Elektroden erzeugten Plasma aktiviert werden. Die verschiedenen reaktiven Bruchstücke der eingeleiteten Gase reagieren mit den an den inneren Oberflächen der Reaktionskammer mit unterschiedlichen Dicken abgeschiedenen Rückständen zu gasförmigen Produkten, die mittels Vakuumpumpen abtransportiert werden.

Zur In-Situ-Reinigung werden gegenwärtig fluorierte Kohlenstoffe, wie $CF_4$, $C_2F_6$ usw., oder andere fluorhaltige Gase, wie $SF_6$, $NF_3$ usw. eingesetzt. Letztere verursachen jedoch wieder eine Verschlechterung der Oberflächenqualität der Kammerinnenteile und ziehen deshalb die bereits zuvor genannten Nachteile nach sich. Andererseits ist bekannt, daß das Ätzen mit $CF_4$ und $C_2F_6$ von einer gleichzeitigen polymeren Abscheidung begleitet wird. Diese im Zuge der Reinigung auftretende unerwünschte Polymerbildung macht sich unter anderem auch indirekt negativ bemerkbar, indem im nächsten Prozeßschritt abgeschiedene Schichten an der Polymerschicht schlecht haften und somit leicht lösbare Partikel auch am Wafer Beschädigungen verursachen können.

In der eingangs zitierten EP-A-354 853 wird deshalb vorgeschlagen, eine erste Ätzgasmischung ($CF_4/O_2$) für die Ätzung von anorganischen Rückständen und ein zweites Ätzgas ($O_2$) für die Ätzung von organischen Rückständen zu verwenden.

Zwar kann also die Polymerbildung durch Zugabe von Sauerstoff ($O_2$) zum Ätzgas verringert werden; ohne Öffnen der Kammer und mechanisches Reinigen bleibt die Reinigungswirkung jedoch meist unbefriedigend. Besonders problematisch ist jedoch die Tatsache, daß das $O_2$-Plasmaätzen von organischen Rückständen ein relativ langsamer Prozeß ist, der ein Mehrfaches der eigentlichen Beschichtungs- bzw. Ätzzeit in Anspruch nimmt und damit zu unverhältnismäßig langen Reinigungszeiten führt.

Der vorliegenden Erfindung liegt die Aufgabe zugrunde, ein gegenüber den genannten Nachteilen verbessertes Verfahren der eingangs genannten Art anzugeben.

Diese Aufgabe wird durch ein Verfahren der eingangs genannten Art gelöst, das dadurch gekennzeichnet ist, daß der Ätzgasmischung

c) ein Ozon-/Sauerstoffgemisch ($O_3/O_2$) mit einer Ozon-Konzentration von 5 bis 20 Volumen-% beigemischt wird,
d) und daß die Ätzgasmischung in der Reaktionskammer durch Zünden eines Plasmas sehr geringer Leistung mit einer Anregungsfrequenz im RF-Bereich angeregt wird und alle Oberflächen in der Reaktionskammer rückstandsfrei mit hoher Ätzrate ätzt.

Erfindungsgemäß wird eine Ozon-Konzentration von 5 bis 20 Volumen-% verwendet. Weitere Einzelheiten und Vorteile der Erfindung werden nachfolgend, auch anhand dreier Ausführungsbeispiele, noch näher erläutert.

Durch die spontane Reaktion des Ozons mit den fluorierten Kohlenstoffen wird lokal sehr viel reaktives Fluor frei, was einen starken Anstieg der Ätzrate der Siliziumoxide oder -nitride zur Folge hat. Gleichzeitig wird die Bildung neuer Polymere gänzlich vermieden, da die Polymere in einer stark oberflächenkontrollierten Reaktion direkt an der Oberfläche vom Ozon angegriffen und sehr schnell in gasförmige Produkte umgewandelt werden. Die erfindungsgemäße Reinigung erfolgt mithin gleichzeitig rückstandsfrei und mit hoher Ätzrate, d.h. die Reinigungszeiten sind - bei gleichzeitiger Materialschonung - kurz. Da Ozon die Ätzaktivität sowohl hinsichtlich des Sauerstoffs wie der fluorierten Kohlenstoffe erhöht, kann beim Reinigungsvorgang die nötige Plasmaleistung reduziert werden. Die Beschleunigungsspannung bzw. die Anregungsfrequenz kann relativ niedrig, etwa im Bereich einiger kHz bis etwa 100 MHz gehalten werden. Damit einher geht eine geringere kinetische Energie der ätzenden Ätzgasteilchen, wodurch die Kammeroberflächen , insbesondere auch die Elektroden, durch Absputtern oder Ionenbombardement weniger geschädigt werden.

Ein weiterer Vorteil ergibt sich daraus, daß durch die Reaktion des Ozons mit den metallischen, vorzugsweise aus Aluminium bestehenden inneren Oberflächen der Reaktionskammer diese passiviert werden und damit einem weiteren Angriff von Ätzgasen besser widerstehen können.

Gemäß der Erfindung kann die Reinigung von organischen Rückständen z. B. nach der Reaktionsgleichung

$$C_xH_yF_z + O_3/O_2 \rightarrow CO_2 + H_2O + H_yC_rF_z$$

bei einem Druck von 100 bis gut 5000 Pa erfolgen. Generell könnte die Ozonkonzentration, was vorteilhafte Ätzergebnisse betrifft, auch oberhalb der aus Sicherheitsgründen gewählten Begrenzung von 20 Volumen-% in $O_2$ liegen.

Das Ätzen von $Si_3N_4$, z. B. in einer CVD-Beschichtungskammer, kann z. B. nach der Reaktionsgleichung

$$Si_3N_4 + 3CF_4 \xrightarrow{O_3} 3SiF_4 + 2N_2 + 3CO_2$$

erfolgen. Das Ätzen einer parasitären Oxidschicht kann z.B. nach der Reaktionsgleichung

$$SiO_2 + CF_4 \xrightarrow{O_3} SiF_4 + CO_2$$

erfolgen. In beiden Fällen wird wieder bei einem Druck von 100 bis gut 5000 Pa und bei einer Temperatur von 300 bis 400°C gearbeitet. Die relativ hohen Drücke werden durch die Verwendung von Ozon ermöglicht. Sie haben zur Folge, daß ein stark lokalisiertes Plasma gezündet werden kann, was die Gefahr einer Schädigung empfindlicher Teile im Innern der Reaktionskammer weiter verringert.

**Patentansprüche**

1. Verfahren zur schnellen und schonenden Reinigung von beim Abscheiden und Ätzen von Schichten auf Siliziumsubstraten verwendeten Reaktionskammern durch Plasmaätzen,

   a) bei dem zur Reinigung der Reaktionskammer von an ihren inneren Oberflächen parasitär abgeschiedenen Schichten aus Siliziumoxiden oder -nitriden eine Ätzgasmischung verwendet wird,
   b) als deren Hauptbestandteil mindestens ein fluorierter Kohlenstoff, insbesondere $CF_4$ und/oder $C_2F_6$ vorgesehen wird, dadurch gekennzeichnet, daß der Ätzgasmischung
   c) ein Ozon-/Sauerstoffgemisch ($O_3/O_2$) mit einer Ozon-Konzentration von 5 bis 20 Volumen-% beigemischt wird,
   d) und daß die Ätzgasmischung in der Reaktionskammer durch Zünden eines Plasmas sehr geringer Leistung mit einer Anregungsfrequenz im RF-Bereich angeregt wird und alle Oberflächen in der Reaktionskammer

rückstandsfrei mit hoher Ätzrate ätzt.

## Claims

1. Process for the rapid and damage-free cleaning by plasma etching of the reaction chambers used in the deposition and etching of layers on silicon substrates,

a) in which, in order to clean up from the reaction chamber layers of silicon oxides or nitrides parasitically deposited on its inner surfaces, use is made of an etching-gas mixture
b) as the main component of which at least one fluorocarbon, in particular $CF_4$ and/or $C_2F_6$, is provided, characterized in that
c) an ozone/oxygen mixture ($O_3/O_2$) with an ozone concentration of 5 to 20 vol.% is added to the etching-gas mixture,
d) and in which the etching-gas mixture in the reaction chamber is excited by striking-up a very low-power plasma with an excitation frequency in the RF range, and all surfaces in the reaction chamber are etched at a high etching rate without leaving a residue.

## Revendications

1. Procédé de nettoyage rapide et ménagé de chambres à réaction utilisées pour le dépôt et la gravure de couches sur des substrats de silicium, par décapage activé par plasma

a) dans lequel, pour débarrasser les chambres à réaction des couches d'oxydes ou de nitrures de silicium déposées d'une manière parasitaire sur leurs surfaces internes, on utilise un mélange de gaz de décapage,
b) un hydrocarbure fluoré, en particulier $CF_4$ et/ou $C_2F_6$ est prévu comme constituant principal de ce mélange,
c) caractérisé en ce que l'on ajoute au mélange de gaz de décapage un mélange ozone/oxygène ($O_3/O_2$) ayant une concentration en ozone de 5 à 20 % en volume,
d) et en ce que l'on excite le mélange de gaz de décapage dans la chambre à réaction par amorçage d'un plasma de très faible puissance ayant une fréquence d'excitation dans le domaine des fréquences radio et en ce que l'on décape toutes les surfaces de la chambre à réaction sans laisser de résidu, avec une grande vitesse de décapage élevée.